# EUROPEAN PATENT SPECIFICATION

(11) **EP 4 068 463 B1**
(45) Date of publication and mention of the grant of the patent: **31.07.2024**
(21) Application number: 21877898.3
(22) Date of filing: 28.09.2021
(51) Int. Cl.: H01M 10/42, B60L 58/26, G01R 31/385, H02J 7/00, H01M 10/48, H01M 10/6561, H01M 10/6563, H01M 50/211, H01M 10/44

(54) **BATTERY CHARGING/DISCHARGING SYSTEM INCLUDING COOLING UNIT ENABLING UNIFORM FLOW RATE DISTRIBUTION**
BATTERIELADE-/ENTLADESYSTEM, DAS EINE KÜHLEINHEIT EINSCHLIESST, DIE EINE GLEICHMÄSSIGE VERTEILUNG DER DURCHFLUSSRATE ERMÖGLICHT
SYSTÈME DE CHARGE/DÉCHARGE DE BATTERIE COMPRENANT UNE UNITÉ DE REFROIDISSEMENT ASSURANT UNE DISTRIBUTION DE DÉBIT UNIFORME

(30) Priority: 08.10.2020 KR 20200129940
(43) Date of publication of application: 05.10.2022
(73) Proprietor: LG Energy Solution, Ltd., Seoul 07335 (KR)
(72) Inventor: GU, Ja Eon, Daejeon 34122 (KR); KONG, Jin Hak, Daejeon 34122 (KR)
(74) Representative: Goddar, Heinz J.
(86) International application number: PCT/KR2021/013189
(87) International publication number: WO 2022/075646

(56) References cited:
- EP-A1- 3 490 029
- JP-A- 2004 014 139
- JP-A- 2007 311 290
- KR-A- 20160 123 852
- KR-B1- 101 262 974
- KR-Y1- 200 169 662
- US-A1- 2006 073 378

## Description

### [Technical Field]

The present invention relates to a battery charge and discharge system including a cooling unit which allows uniform distribution of flow rate.

### [Background Art]

EP 3 490 029 A1 relates to a battery module, a power battery pack and a vehicle.

US 2006/0733778 relates to the difficulty to provide an effective, regulated and uniform cooling of multiple batteries, regardless of their location within a module. US 2006/073378 A1 discloses to devices for cooling batteries of an electrically and/or hybrid powered vehicle which work by circulating air around a plurality of juxtaposed battery cells. According to one embodiment, columns of batteries are housed inside cavities which are formed from a plurality of stacked plates having windows through which the columns pass.

Recently, as technology development and demand for mobile devices increase, the demand for secondary batteries as energy sources is rapidly increasing.

The secondary battery may be used in the form of a single battery cell or a module, in which a plurality of unit batteries is electrically connected, depending on the type of an external device. For example, a small device such as a mobile phone can be operated for a predetermined time with one battery cell output and capacity, but medium and large devices such as a notebook computer, a portable DVD, a personal computer, an electric vehicle, and a hybrid electric vehicle need a battery module including a plurality of battery cells due to the output and capacity requirements.

Further, the secondary battery is manufactured through a process of assembling a battery cell and a process of activating the battery. At this time the activation process of the battery is performed as a charge/discharge device applies a necessary electric current to the target battery cell.

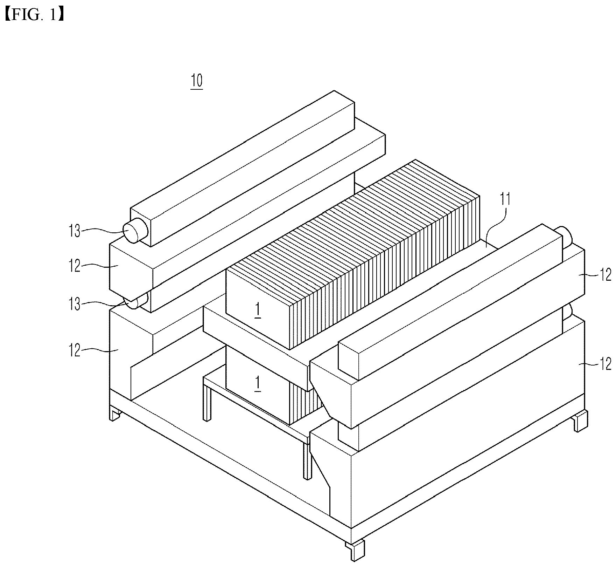

FIG. 1 is a diagram showing a conventional system for charging and discharging a secondary battery. As illustrated in FIG. 1, a conventional system 10 for charging and discharging a secondary battery includes: a tray 11 which accommodates a plurality of battery cells 1; a charge and discharge unit 12 having a structure which may be electrically connected to a positive electrode and a negative electrode protruding from the battery cells 1 accommodated in the tray 11; and a cooling unit 13 capable of emitting heat generated in the battery cells 1 in the process of activating the battery cells 1 by repeated charge and discharge.

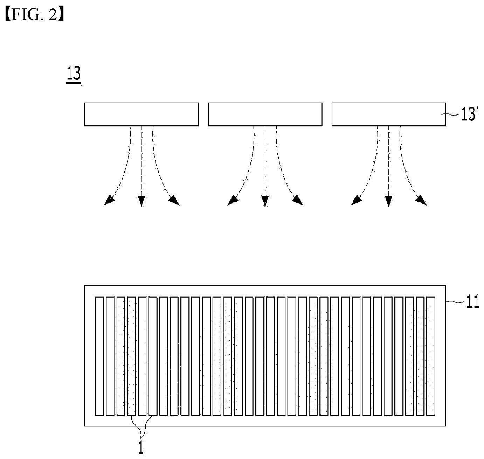

FIG. 2 is a diagram schematically showing a cooling unit in a conventional system for charging and discharging a secondary battery. As illustrated in FIG. 2, the cooling unit 13 of the conventional system 10 for charging and discharging a secondary battery is configured to include a plurality of blowing fans 13' directed toward the tray 11 where a plurality of battery cells 1 are accommodated. However, since the conventional cooling unit 13 was used to emit overall heat of the battery cells 1 accommodated in the tray 11, there may be a temperature difference, depending on the position where the battery cells 1 are accommodated.

Likewise, when there is a temperature difference in the battery cells 1 in the process of charging and discharging the battery cells 1, the capacity deviation of the battery cells 1 may occur. As such, when it is necessary to determine whether there is a defect based on the measurement value about the capacity of the battery cells 1 during the charge and discharge, it may be difficult to clearly determine whether there is a defect in the battery cells 1 based thereon.

Therefore, there is a need for a battery charge and discharge system including a cooling unit which allows uniform distribution of flow rate in order to cool heat generated in a battery cell while charging and discharging the battery cell.

### [Prior art literature]

### [Patent Document]

Korea Patent Publication No. 10-2015-0034945

### [Disclosure]

### [Technical Problem]

The present invention is believed to solve at least some of the above problems. For example, an aspect of the present invention provides a battery charge and discharge system including a cooling unit which allows uniform distribution of flow rate.

### [Technical Solution]

The present invention provides a system for charging and discharging a battery. In one example, a system for charging and discharging a battery according to the present invention includes: a tray configured to accommodate a plurality of battery cells; a charge and discharge unit configured to be electrically connected to first and second electrode leads of the plurality of battery cells accommodated in the tray; and a cooling unit configured to cool the plurality of battery cells accommodated in the tray. Herein, the cooling unit includes an air supply unit positioned at an upper portion of the tray, and n perforated plates which are positioned on an air flow path of the air supply unit, the perforated plates being arranged in a lamination structure. Herein, n is an integer equal to or greater than 2.

In a first alternative according to the present disclosure , each of the perforated plates has a plurality holes, and the holes are located in a central region of the perforated plate.

In a second a first alternative according to the present disclosure, each of the perforated plates has a plurality of holes, and a diameter of the holes located in a central region of the perforated plate is greater than a diameter of the holes located at an edge region of the perforated plate.

In a third alternative according to the present disclosure, each of the perforated plates has a plurality of slits parallel to each other, and the slits are located in a central region of the perforated plate.

In a fourth alternative according to the present disclosure, each of the perforated plates has a plurality of slits, and a width of the slits located in a central region of the perforated plate is greater than a width of the slits located at an edge region of the perforated plate.

In one example, the cooling unit has a structure where 2 to 5 perforated plates are laminated.

In a specific example, the air supply unit is provided as a plurality of air supply units, and the air supply units are arranged at the upper portion of the tray at regular intervals. Further, the air supply unit may be a blowing fan.

In one example, the plurality of battery cells accommodated in the tray are vertically arranged, and the cooling unit is configured to blow air to move downwards through the air supply unit positioned at the upper portion of the tray. At this time, the plurality of battery cells accommodated in the tray may be pouch-type battery cells.

In another example, the tray has an open side surface, and the cooling unit further includes a sub-air supply unit which blows cooling air toward the battery cells at the open side surface of the tray.

In one example, the system for charging and discharging a battery according to the present invention further includes a temperature sensor which measures a temperature of the battery cells accommodated in the tray.

### [Advantageous Effects]

According to a battery charge and discharge system including a cooling unit which allows uniform distribution of flow rate of the present invention, it is possible to minimize the temperature difference between a plurality of battery cells.

### [Brief Description of the Drawings]

FIG. 1 is a diagram showing a conventional system for charging and discharging a secondary battery.
FIG. 2 is a diagram schematically showing a cooling unit in a conventional system for charging and discharging a secondary battery.
FIG. 3 is a schematic diagram of a system for charging and discharging a battery according to one embodiment of the present invention.
FIG. 4 is a schematic diagram of a cooling unit in a system for charging and discharging a battery according to one embodiment of the present invention.
FIG. 5 is graph showing measurement values obtained by measuring the temperature according to the location of battery cells accommodated in a tray in a conventional charge and discharge system and a battery charge and discharge system including a cooling unit according to a first embodiment of the present invention.
FIG. 6 is a diagram schematically showing a perforated plate of a cooling unit in a system for charging and discharging a battery according to another embodiment of the present invention.
FIG. 7 is a diagram schematically showing a perforated plate of a cooling unit in a system for charging and discharging a battery according to further another embodiment of the present invention.
FIG. 8 is a diagram schematically showing a perforated plate of a cooling unit in a system for charging and discharging a battery according to further another embodiment of the present invention.
FIG. 9 is a schematic diagram of a system for charging and discharging a battery according to another embodiment of the present invention.

### [Detailed Description of the Preferred Embodiments]

Hereinafter, the present invention will be described in detail with reference to the drawings. The terms and words used in the present specification and claims should not be construed as limited to ordinary or dictionary terms and the inventor may properly define the concept of the terms in order to best describe its invention. The terms and words should be construed as meaning and concept consistent with the technical idea of the present invention.

In this application, it should be understood that terms such as "include" or "have" are intended to indicate that there is a feature, number, step, operation, component, part, or a combination thereof described on the specification, and they do not exclude in advance the possibility of the presence or addition of one or more other features or numbers, steps, operations, components, parts or combinations thereof. Also, when a portion such as a layer, a film, an area, a plate, etc. is referred to as being "on" another portion, this includes not only the case where the portion is "directly on" the another portion but also the case where further another portion is interposed therebetween. On the other hand, when a portion such as a layer, a film, an area, a plate, etc. is referred to as being "under" another portion, this includes not only the case where the portion is "directly under" the another portion but also the case where further another portion is interposed therebetween. In addition, to be disposed "on" in the present application may include the case disposed at the bottom as well as the top.

The present invention relates to a battery charge and discharge system including a cooling unit which allows uniform distribution of flow rate.

In the conventional battery charge and discharge system, the cooling unit was used to emit overall heat of battery cells accommodated in a tray. Herein, there was a temperature difference between a plurality of battery cells accommodated in the tray according to the accommodated location. In this case, when it is necessary to determine whether there is a defect based on the measurement value about the capacity of the battery cells during the charge and discharge, it may be difficult to clearly determine whether there is a defect in the battery cells due to the capacity deviation.

As such, the present invention provides a battery charge and discharge system including a cooling unit which allows uniform distribution of flow rate. Particularly, since the battery charge and discharge system according to the present invention includes n perforated plates which form a lamination structure on a flow path of the cooling unit, it is possible to maintain the flow rate of the air, which passes through the holes of the perforated plates, constant. As such, the battery charge and discharge system according to the present invention can minimize the temperature difference between the battery cells accommodated in the tray.

Hereinafter, a battery charge and discharge system including a cooling unit which allows uniform distribution of flow rate according to the present invention will be described in detail.

In one example, a system for charging and discharging a battery according to the present invention includes: a tray which accommodates a plurality of battery cells; a charge and discharge unit which is electrically connected to first and second electrode leads formed at a plurality of battery cells accommodated in the tray; and a cooling unit which cools a plurality of battery cells accommodated in the tray. In one embodiment, the cooling unit includes an air supply unit positioned at an upper portion of the tray, and n perforated plates which are positioned on an air flow path of air by an air supply unit and form a lamination structure. Herein, the n is an integer equal to or greater than 2.

In one embodiment, the tray is a rectangular box having an open top, and a plurality of battery cells are arranged in a matrix shape in the tray. At this time, the height of the tray is formed to correspond to the height of the battery cell. Further, two side surfaces are perforated so that the first and second electrode leads of the accommodated battery cells may protrude. In a specific example, since two side surfaces of the tray are perforated, first and second electrode leads of the battery cells accommodated in the tray may be connected to the external side. For example, the first and second electrode leads of the battery cell accommodated in the tray are electrically connected to the charge and discharge unit to be described later.

In one embodiment, the charge and discharge unit is positioned at two side surfaces of the tray and is electrically connected to first and second electrode leads of a plurality of battery cells accommodated in the tray. In a specific example, the charge and discharge unit may be coupled to supply power to the plurality of battery cells accommodated in the tray and charge and discharge the battery cells a predetermined number of times for predetermined time with a predetermined voltage. Further, the charge and discharge unit includes a controller (not shown) which can monitor the charge and discharge state during the charge and discharge of the battery cells and control various jobs of coming back to the original position after job completion. A specific description thereof will be omitted.

In one embodiment, the system for charging and discharging a battery according to the present invention includes a cooling unit which cools a plurality of battery cells. In a specific example, in a system for charging and discharging a battery, for example, if the temperature of the battery cells becomes 50°C or higher during the charge and discharge of the battery cells, the efficiency or performance of the battery cells decreases, the durability of the battery cells decreases, and a risk such as an explosion by heat may increase. Hence, it is preferable to reduce the temperature of the battery by emitting heat generated during the charge and discharge of the battery cells by using the cooling unit according to the present invention. Further, it is desirable to allow the uniform degree of heat to be emitted from the battery cells in the same battery cell laminate and reduce the temperature variation in the battery cells during the process of charging and discharging the battery cells because a large temperature variation may affect the efficiency, stability and durability of the battery cells.

In one embodiment, the cooling unit can cool a plurality of battery cells by inducing air to flow in a direction corresponding to the direction in which the plurality of battery cells is placed. In a specific example, the cooling unit includes an air supply unit positioned at an upper portion of the tray, and n perforated plates which are positioned on an air flow path of air by an air supply unit and form a lamination structure. Herein, the n is an integer equal to or greater than 2.

In one embodiment, the air supply unit is a blowing fan of a generally widely used propeller form, and is located on the upper portion of the tray. Further, the air supply unit is installed on the upper portion of n perforated plates to be described later and blows air downwards. The air blown downwards may flow into the inside of the tray through air flow path perforated on the perforated plate. Further, the cooling unit includes a plurality of air supply units, and the air supply units are arranged on an upper portion of the tray at regular intervals. The cooling unit may have a structure where 2 to 5 perforated plates are laminated or a structure where 3 to 5 perforated plates are laminated. For example, 3 perforated plates may be laminated.

In one embodiment, the n perforated plates allow air blown from the air supply unit to flow into the tray. For example, since the cooling unit has 3 perforated plates, the flow rate may gradually become uniform as air blown by the air supply unit passes through holes formed on the three perforated plates.

In one example, each of the perforated plates has a plurality holes, and the holes are formed in a central region of the perforated plate. Particularly, as less air is supplied to the region where the battery cells accommodated in the outermost side are located by such a structure, the temperature variation of the battery cells accommodated in the tray may decrease. As such, it is possible to minimize the temperature difference between battery cells by allowing uniform distribution of flow rate.

In another example, each of the perforated plates has a plurality of holes, and a diameter of holes formed in the central region of the perforated plate is greater than a diameter of holes formed in an edge region of the perforated plate. Specifically, the diameter of the holes formed on the perforated plate gradually decreases from the central region to the edge region. The structure is used to reduce the amount of air supplied to the edge region of the tray while supplying air of the air supply unit to the tray where a plurality of battery cells is accommodated.

In another embodiment, each of the perforated plates has a plurality of slits parallel to each other. The air supplied from the air supply unit may flow into the tray through a plurality of slits formed on the perforated plate. In a specific example, the slits are formed in a direction parallel to a direction in which battery cells are accommodated in the tray, and particularly, the slits may be formed in the central region of the perforated plate.

In another embodiment, each of the perforated plates has a plurality of slits parallel to each other. The air supplied from the air supply unit may flow into the tray through a plurality of slits formed on the perforated plate. In a specific example, the slits are formed in a direction parallel to a direction in which battery cells are accommodated in the tray. Further, the width of slits formed in the central region of the perforated plate is greater than the width of slits formed in the edge region of the perforated plate. For example, the width of the holes formed on the perforated plate gradually decreases from the central region to the edge region. The structure is used to reduce the amount of air supplied to the edge region of the tray while supplying air of the air supply unit to the tray where a plurality of battery cells are accommodated.

In another example, a system for charging and discharging a battery according to the present invention includes: a tray which accommodates a plurality of battery cells; a charge and discharge unit which is electrically connected to first and second electrode leads formed at a plurality of battery cells accommodated in the tray; and a cooling unit which cools a plurality of battery cells accommodated in the tray.

In another embodiment, the cooling unit can cool a plurality of battery cells by inducing air to flow in a direction corresponding to the direction in which the plurality of battery cells is placed. Specifically, the cooling unit includes an air supply unit positioned at an upper portion of the tray, and n perforated plates which are positioned on an air flow path of air by an air supply unit and form a lamination structure. Herein, the n is an integer equal to or greater than 2.

Further, the size and shape of the holes formed on the n perforated plates may vary, depending on the layer. In a specific example, in the case of the perforated plate at the upper end, a plurality of holes is formed in the central region of the perforated plate, and in the case of the perforated plate at the lower end, a plurality of holes are formed over the entire region of the perforated plate. Further, the size of holes of the perforated plate gradually decreases from the upper end to the lower end.

Particularly, as less air is supplied to the region where the battery cells accommodated in the outermost side are located by such a structure, the temperature variation of the battery cells accommodated in the tray may decrease. As such, it is possible to minimize the temperature difference between battery cells by allowing uniform distribution of flow rate.

Further, the system for charging and discharging a battery according to the present invention may further include a sub-air supply unit. In a specific example, the sub-air supply unit blows cooling air from the side surface of the tray toward the battery cells. The sub-air supply unit may be installed at two sides of the tray to induce air in a direction corresponding to the direction in which the plurality of battery cells is placed.

In one example, the plurality of battery cells accommodated in the tray are vertically arranged, and the cooling unit blows air to move downwards through a blowing fan positioned at an upper portion of the tray. Further, the battery cells may mean a battery cell laminate obtained by laminating 2 to 30, 5 to 20, or 10 to 16 battery cells.

In one embodiment, the plurality of battery cells accommodated in the tray may be pouch-type battery cells. In a specific example, the battery cell is a pouch type unit cell, and an electrode assembly having a positive electrode/ separator/ negative electrode structure is embedded in an exterior material of the laminate sheet in a state that is connected to electrode leads formed outside the exterior material. The electrode leads may be drawn to the outside of the sheet and may be extended in the same or opposite direction to each other.

Figures of the present invention show only a pouch-type battery cell having a form where a pair of electrode leads are withdrawn in the opposite direction for the convenience of explanation, but the battery cell, which is applied to the battery module according to the present invention, is not particularly limited thereto, and a pair of electrode leads may be withdrawn in the same direction.

Further, the system for charging and discharging a battery according to the present invention may further include a temperature sensor which measures a temperature of the battery cells. In a specific example, it is possible to determine whether the cooling unit has a breakdown by the temperature sensor. For example, the controller may automatically determine a state by a rapid temperature change sensed by the temperature sensor and generate a warning message.

### [Detailed Description of the Preferred Embodiments]

Hereinafter, the present invention will be described in more detail through drawings and the like. However, the embodiments described in the specification and the configurations described in the drawings are only the most preferred embodiments of the present invention, and do not represent all of the technical ideas of the present invention. It is to be understood that there may be various equivalents and variations in place of them.

### (First embodiment)

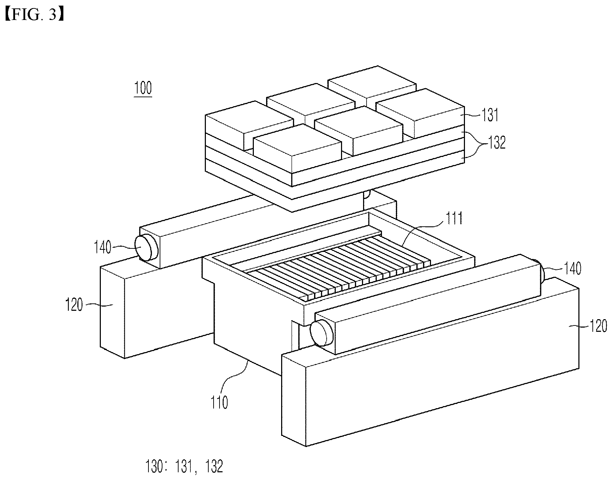

FIG. 3 is a schematic diagram of a system for charging and discharging a battery according to one embodiment of the present invention. Referring to FIG. 3, a system 100 for charging and discharging a battery according to the present invention includes: a tray 110 which accommodates a plurality of battery cells 111; a charge and discharge unit 120 which is electrically connected to first and second electrode leads formed at a plurality of battery cells 111 accommodated in the tray 110; and a cooling unit 130 which cools a plurality of battery cells 111 accommodated in the tray 110.

First, the tray 110 is a rectangular box having an open top, and a plurality of battery cells 111 are arranged in a matrix shape in the tray. Herein, the height of the tray 110 is formed to correspond to the height of the battery cell 111. Further, the tray 110 has a structure that two side surfaces are perforated so that the first and second electrode leads of the accommodated battery cells may protrude. Specifically, since two side surfaces of the tray 110 are perforated, first and second electrode leads of the battery cells 111 accommodated in the tray may be connected to the external side. For example, the first and second electrode leads of the battery cell 111 accommodated in the tray 110 are electrically connected to the charge and discharge unit 120 to be described later.

Further, the charge and discharge unit 120 is positioned at two side surfaces of the tray 110 and is electrically connected to first and second electrode leads of a plurality of battery cells 111 accommodated in the tray 110. In a specific example, the charge and discharge unit 120 may be coupled to supply power to the plurality of battery cells 111 accommodated in the tray 110 and charge and discharge the battery cells 111 a predetermined number of times for predetermined time with a predetermined voltage. Further, the charge and discharge unit includes a controller (not shown) which can monitor the charge and discharge state during the charge and discharge of the battery cells 111 and control various jobs of coming back to the original position after job completion. A specific description thereof will be omitted.

The cooling unit 130 may induce air in a direction corresponding to the direction in which the plurality of battery cells 111 accommodated in the tray 110 are placed, to thereby cool the plurality of battery cells 111. Specifically, the cooling unit 130 includes an air supply unit 131 positioned at an upper portion of the tray 110, and n perforated plates 132 which are positioned on an air flow path of air by an air supply unit 131 and form a lamination structure. Herein, the n is an integer equal to or greater than 2.

The air supply unit 131 is a blowing fan of a generally widely used propeller form, and is located on the upper portion of the tray 110. Further, the air supply unit 131 is installed on the upper portion of n perforated plates 132 to be described later and blows air downwards. The air blown downwards may flow into the inside of the tray through air flow path perforated on the perforated plate. Further, the cooling unit includes a plurality of air supply units 131, and the air supply units are arranged on an upper portion of the tray 110 at regular intervals. In FIG. 3, it is illustrated to include 6 blowing fans, but the present invention is not limited this example.

The cooling unit 130 according to the present invention includes n perforated plates 132 as described above. In FIG. 3, it is illustrated to include 3 perforated plates 132, but the present invention is not limited to this example.

Further, a system 100 for charging and discharging a battery according to the present invention includes a sub-air supply unit 140. The sub-air supply unit 140 blows cooling air from the side surface of the tray 110 toward the battery cells 111. The sub-air supply unit 140 may be installed at two sides of the tray to induce air in a direction corresponding to the direction in which the plurality of battery cells is placed.

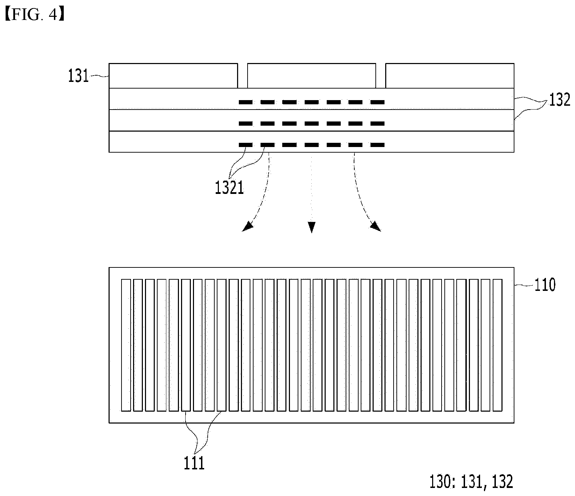

FIG. 4 is a schematic diagram of a cooling unit in a system for charging and discharging a battery according to one embodiment of the present invention. Referring to FIG. 4, the 3 perforated plates 132 allow air blown from the air supply unit to flow into the tray 110. Particularly, since the cooling unit 130 has 3 perforated plates 132, the flow rate may gradually become uniform as air blown by the air supply unit 131 passes through holes formed on the three perforated plates 132.

Further, each of the perforated plates 132 has a plurality of holes 1321, and the holes 1321 are formed in a central region of the perforated plate 132. Particularly, as less air is supplied to the region where the battery cells 111 accommodated in the outermost side of the tray 110 are located by such a structure, the temperature variation of the battery cells accommodated in the tray 110 may decrease. As such, it is possible to minimize the temperature difference between battery cells by allowing uniform distribution of flow rate.

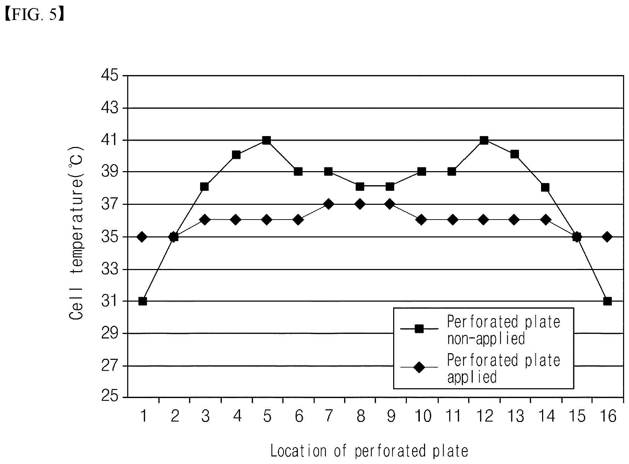

In this regard, temperatures according to locations of battery cells accommodated in a tray in a conventional charge and discharge system and a battery charge and discharge system including a cooling unit according to a first embodiment of the present invention were measured. And the result is shown in FIG. 5.

FIG. 5 is graph showing measurement values obtained by measuring the temperature according to the location of battery cells accommodated in a tray in a conventional charge and discharge system and a battery charge and discharge system including a cooling unit according to a first embodiment of the present invention.

Referring to FIG. 5, in the case of a conventional battery charge and discharge system, the temperature at the outermost battery cell of the tray was 3 1°C, and the temperature of the battery cell in the central region was 41°C. Namely, the temperature of the battery cells was different according to the location in the tray, and there was a large temperature difference. However, in the battery charge and discharge system of the present invention, the temperature difference of 16 battery cells accommodated in the tray was small. Herein, it is understood that it is possible to minimize the temperature difference between the battery cells by allowing uniform distribution of flow rate by including 3 perforated plates in the cooling unit.

### (Second embodiment)

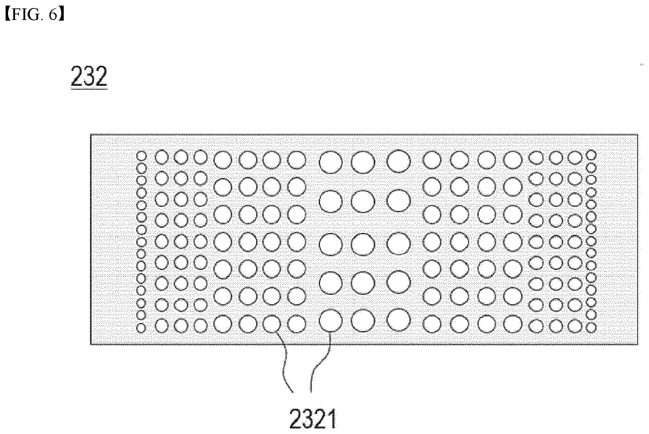

FIG. 6 is a diagram schematically showing a perforated plate of a cooling unit in a system for charging and discharging a battery according to another embodiment of the present invention. Referring to FIG. 6, the perforated plate 232 according to the present invention has a plurality of holes 2321. The air supplied from the air supply unit may flow into the tray through a plurality of holes 2321 formed on the perforated plate 232.

Further, the diameter of holes 2321 formed in the central region of the perforated plate 232 is greater than the diameter of holes 2321 formed in the edge region of the perforated plate 232. Specifically, the diameter of the holes 2321 formed on the perforated plate 232 gradually decreases from the central region to the edge region.

The structure is used to reduce the amount of air supplied to the edge region of the tray while supplying air of the air supply unit to the tray where a plurality of battery cells are accommodated.

Since each component has been described above, the detailed description of each component will be omitted here.

### (Third embodiment)

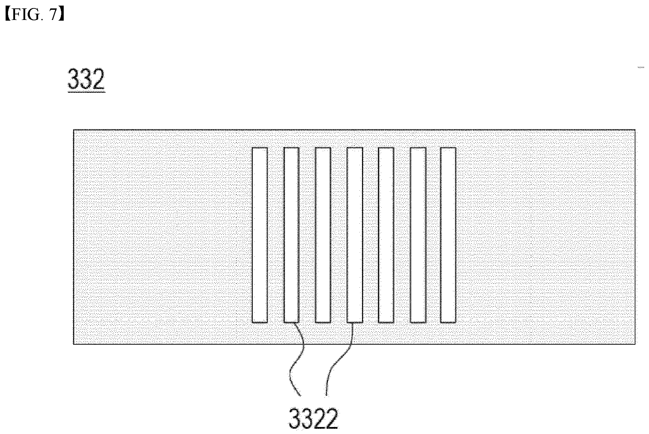

FIG. 7 is a diagram schematically showing a perforated plate of a cooling unit in a system for charging and discharging a battery according to further another embodiment of the present invention. Referring to FIG. 7, the perforated plate 332 according to the present invention has a plurality of slits 3322 parallel to each other. The air supplied from the air supply unit may flow into the tray through a plurality of slits 3322 formed on the perforated plate 332.

The slits 3322 are formed in a direction parallel to a direction in which battery cells are accommodated in the tray, and particularly, the slits 3322 are formed in the central region of the perforated plate 332.

The structure is used to reduce the amount of air supplied to the edge region of the tray while supplying air of the air supply unit to the tray where a plurality of battery cells is accommodated.

Since each component has been described above, the detailed description of each component will be omitted here.

### (Fourth embodiment)

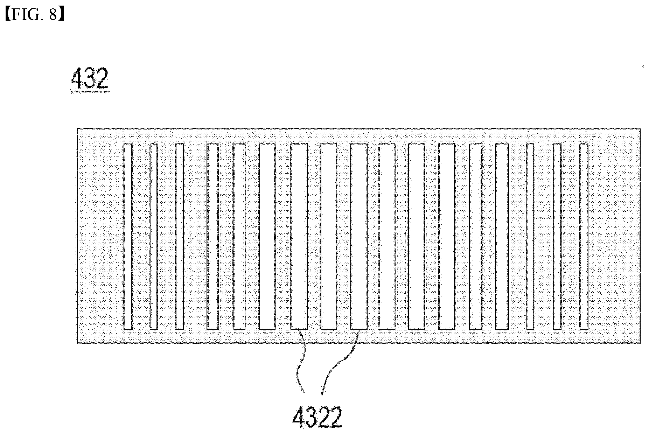

FIG. 8 is a diagram schematically showing a perforated plate of a cooling unit in a system for charging and discharging a battery according to further another embodiment of the present invention. Referring to FIG. 8, the perforated plate 432 according to the present invention has a plurality slits 4322 parallel to each other. The air supplied from the air supply unit may flow into the tray through a plurality of slits 4322 formed on the perforated plate 432.

The slits 4322 are formed in a direction parallel to a direction in which battery cells are accommodated in the tray. Further, the width of slits 4322 formed in the central region of the perforated plate 432 is greater than a width of slits 4322 formed in an edge region of the perforated plate 432. Specifically, the width of the holes 4321 formed on the perforated plate 432 gradually decreases from the central region to the edge region.

The structure is used to reduce the amount of air supplied to the edge region of the tray while supplying air of the air supply unit to the tray where a plurality of battery cells are accommodated.

Since each component has been described above, the detailed description of each component will be omitted here.

### (Fifth embodiment)

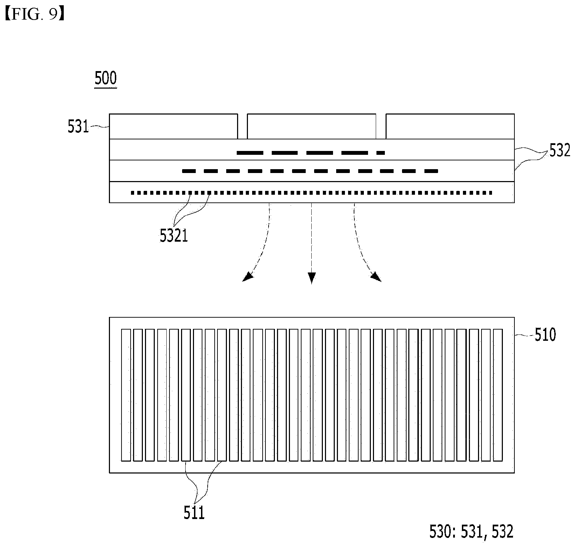

FIG. 9 is a schematic diagram of a system for charging and discharging a battery according to another embodiment of the present invention.

Referring to FIG. 9, a system 500 for charging and discharging a battery according to the present invention includes: a tray 510 which accommodates a plurality of battery cells 511; a charge and discharge unit (not shown) which is electrically connected to first and second electrode leads formed at a plurality of battery cells 511 accommodated in the tray 510; and a cooling unit 530 which cools a plurality of battery cells 511 accommodated in the tray 510.

The cooling unit 530 may induce air in a direction corresponding to the direction in which the plurality of battery cells 511 accommodated in the tray 510 are placed, to thereby cool the plurality of battery cells 511. Specifically, the cooling unit 530 includes an air supply unit 531 positioned at an upper portion of the tray 510, and n perforated plates 532 which are positioned on an air flow path of air by an air supply unit 531 and form a lamination structure. Herein, the n is an integer equal to or greater than 2. In FIG. 9, it is illustrated to include 3 perforated plates 532, but the present invention is not limited to this example.

The 3 perforated plates 532 allow air blown from the air supply unit 531 to flow into the tray 510. Particularly, since the cooling unit 530 has 3 perforated plates 532, the flow rate may gradually become uniform as air blown by the air supply unit 531 passes through holes 5321 formed on the three perforated plates 532.

Further, the size and shape of the holes 5321 formed on the 3 perforated plates may vary, depending on the layer. Specifically, in the case of the perforated plate 532 at the upper end, a plurality of holes 5321 are formed in the central region of the perforated plate 532, and in the case of the perforated plate 532 at the lower end, a plurality of holes 5321 are formed over the entire region of the perforated plate. Further, the size of holes 5321 of the perforated plate 532 gradually decreases from the upper end to the lower end.

Particularly, as less air is supplied to the region where the battery cells 511 accommodated in the outermost side of the tray 510 are located by such a structure, the temperature variation of the battery cells accommodated in the tray 510 may decrease. As such, it is possible to minimize the temperature difference between battery cells 511 by allowing uniform distribution of flow rate.

The above description is merely illustrative of the technical idea of the present invention, and those skilled in the art to which the present invention pertains may make various modifications and variations without departing from the scope of the appended claims.

Therefore, the drawings disclosed in the present invention are not intended to limit the technical idea of the present invention but to describe the present invention, and the scope of the technical idea of the present invention is not limited by these drawings.

On the other hand, in this specification, terms indicating directions such as up, down, left, right, before, and after are used, but it is obvious that these terms are for convenience of description only and may change depending on the location of the object or the location of the observer.

### [Description of reference numerals]

1: battery cell
10, 100: system for charging and discharging battery
11, 110: tray
111, 511: battery cell
12, 120: charge and discharge unit
13, 130: cooling unit
131, 531: air supply unit
132, 232, 332, 432, 532: perforated plate
1321, 2321, 5321: hole
3322, 4322: slit

## Claims

1. A system for charging and discharging a battery, the system comprising:
a tray (110) configured to accommodate a plurality of battery cells (111, 511);
a charge and discharge unit (120) configured to be electrically connected to first and second electrode leads of the plurality of battery cells (111, 511) accommodated in the tray (110); and
a cooling unit (130) configured to cool the plurality of battery cells (111, 511) accommodated in the tray (110),
wherein the cooling unit (130) includes an air supply unit (131, 531) positioned at an upper portion of the tray (110), and n perforated plates (132, 232, 332, 432, 532) which are positioned on an air flow path of the air supply unit (131, 531), the perforated plates (132, 232, 332, 432, 532) being arranged in a lamination structure, and the air supply unit (131, 531) being installed on the upper portion of the n perforated plates (132, 232, 332, 432, 532);
and
wherein n is an integer equal to or greater than 2, **characterized in that** each of the perforated plates (132, 232, 332, 432, 532) has a plurality holes (1321, 2321, 5321), and the holes (1321, 2321, 5321) are located in a central region of the perforated plate (132, 232, 332, 432, 532).

2. A system for charging and discharging a battery, the system comprising:
a tray (110) configured to accommodate a plurality of battery cells (111, 511);
a charge and discharge unit (120) configured to be electrically connected to first and second electrode leads of the plurality of battery cells (111, 511) accommodated in the tray (110); and
a cooling unit (130) configured to cool the plurality of battery cells (111, 511) accommodated in the tray (110),
wherein the cooling unit (130) includes an air supply unit (131, 531) positioned at an upper portion of the tray (110), and n perforated plates (132, 232, 332, 432, 532) which are positioned on an air flow path of the air supply unit (131, 531), the perforated plates (132, 232, 332, 432, 532) being arranged in a lamination structure, and the air supply unit (131, 531) being installed on the upper portion of the n perforated plates (132, 232, 332, 432, 532);
and
wherein n is an integer equal to or greater than 2, **characterized in that**
each of the perforated plates (132, 232, 332, 432, 532) has a plurality of holes (1321, 2321, 5321) (1321, 2321, 5321), and
wherein a diameter of the holes (1321, 2321, 5321) located in a central region of the perforated plate (132, 232, 332, 432, 532) is greater than a diameter of the holes (1321, 2321, 5321) located at an edge region of the perforated plate (132, 232, 332, 432, 532).

3. A system for charging and discharging a battery, the system comprising:
a tray (110) configured to accommodate a plurality of battery cells (111, 511);
a charge and discharge unit (120) configured to be electrically connected to first and second electrode leads of the plurality of battery cells (111, 511) accommodated in the tray (110); and
a cooling unit (130) configured to cool the plurality of battery cells (111, 511) accommodated in the tray (110),
wherein the cooling unit (130) includes an air supply unit (131, 531) positioned at an upper portion of the tray (110), and n perforated plates (132, 232, 332, 432, 532) which are positioned on an air flow path of the air supply unit (131, 531), the perforated plates (132, 232, 332, 432, 532) being arranged in a lamination structure, and the air supply unit (131, 531) being installed on the upper portion of the n perforated plates (132, 232, 332, 432, 532);
and
wherein n is an integer equal to or greater than 2, **characterized in that**
each of the perforated plates (132, 232, 332, 432, 532) has a plurality slits (3322, 4322) parallel to each other, and the slits (3322, 4322) are located in a central region of each perforated plate (132, 232, 332, 432, 532).

4. A system for charging and discharging a battery, the system comprising:
a tray (110) configured to accommodate a plurality of battery cells (111, 511);
a charge and discharge unit (120) configured to be electrically connected to first and second electrode leads of the plurality of battery cells (111, 511) accommodated in the tray (110); and
a cooling unit (130) configured to cool the plurality of battery cells (111, 511) accommodated in the tray (110),
wherein the cooling unit (130) includes an air supply unit (131, 531) positioned at an upper portion of the tray (110), and n perforated plates (132, 232, 332, 432, 532) which are positioned on an air flow path of the air supply unit (131, 531), the perforated plates (132, 232, 332, 432, 532) being arranged in a lamination structure, and the air supply unit (131, 531) being installed on the upper portion of the n perforated plates (132, 232, 332, 432, 532);
and
wherein n is an integer equal to or greater than 2, **characterized in that**
each of the perforated plates (132, 232, 332, 432, 532) has a plurality of slits (3322, 4322), and
wherein a width of the slits located in a central region of the perforated plate (132, 232, 332, 432, 532) is greater than a width of the slits (3322, 4322) located at an edge region of the perforated plate (132, 232, 332, 432, 532).

5. The system of one of the preceding claims, wherein n is an integer from 2 to 5.

6. The system of one of the preceding claims, wherein the air supply unit (131, 531) is provided as a plurality of air supply units (131, 531), and the air supply units (131, 531) are arranged at the upper portion of the tray (110) at regular intervals.

7. The system of one of the preceding claims, wherein the air supply unit (131, 531) is a blowing fan.

8. The system of one of the preceding claims, wherein the plurality of battery cells (111, 511) accommodated in the tray (110) are vertically arranged, and
wherein the cooling unit (130) is configured to blow air to move downwards through the air supply unit (131, 531) positioned at the upper portion of the tray (110).

9. The system of one of the preceding claims, wherein the plurality of battery cells (111, 511) accommodated in the tray (110) are pouch-type battery cells (111, 511).

10. The system of one of the preceding claims, wherein the tray (110) has an open side surface, and
wherein the cooling unit (130) further includes a sub-air supply unit (140) which blows cooling air toward the battery cells (111, 511) at the open side surface of the tray (110).

11. The system of one of the preceding claims, further comprising a temperature sensor which measures a temperature of the battery cells (111, 511) accommodated in the tray (110).

## Patentansprüche

1. System zum Laden und Entladen einer Batterie, wobei das System Folgendes aufweist:
ein Fach (110), das eingerichtet ist, mehrere Batteriezellen (111, 511) aufzunehmen;
eine Lade- und Entladeeinheit (120), die eingerichtet ist, mit einer ersten Elektrodenleitung und einer zweiten Elektrodenleitung der mehreren Batteriezellen (111, 511), die in dem Fach (110) aufgenommen sind, elektrisch verbunden zu werden; und
eine Kühleinheit (130), die eingerichtet ist, die mehreren Batteriezellen (111, 511), die in dem Fach (110) aufgenommen sind, zu kühlen,
wobei die Kühleinheit (130) eine Luftzuführeinheit (131, 531), die an einem oberen Abschnitt des Fachs (110) positioniert ist, und n perforierte Platten (132, 232, 332, 432, 532) aufweist, die auf einem Luftströmungsweg der Luftzuführeinheit (131, 531) positioniert sind, wobei die perforierten Platten (132, 232, 332, 432, 532) in einer Laminierungsstruktur angeordnet sind und die Luftzuführeinheit (131, 531) an dem oberen Abschnitt der n perforierten Platten (132, 232, 332, 432, 532) installiert ist; und
wobei n eine ganze Zahl gleich oder größer als 2 ist, **dadurch gekennzeichnet, dass** jede der perforierten Platten (132, 232, 332, 432, 532) mehrere Löcher (1321, 2321, 5321) aufweist und die Löcher (1321, 2321, 5321) in einem zentralen Bereich der perforierten Platte (132, 232, 332, 432, 532) angeordnet sind.

2. System zum Laden und Entladen einer Batterie, wobei das System Folgendes aufweist:
ein Fach (110), das eingerichtet ist, mehrere Batteriezellen (111, 511) aufzunehmen;
eine Lade- und Entladeeinheit (120), die eingerichtet ist, mit einer ersten Elektrodenleitung und einer zweiten Elektrodenleitung der mehreren Batteriezellen (111, 511), die in dem Fach (110) aufgenommen sind, elektrisch verbunden zu werden; und
eine Kühleinheit (130), die eingerichtet ist, die mehreren Batteriezellen (111, 511), die in dem Fach (110) aufgenommen sind, zu kühlen,
wobei die Kühleinheit (130) eine Luftzuführeinheit (131, 531), die an einem oberen Abschnitt des Fachs (110) positioniert ist, und n perforierte Platten (132, 232, 332, 432, 532) aufweist, die auf einem Luftströmungsweg der Luftzuführeinheit (131, 531) positioniert sind, wobei die perforierten Platten (132, 232, 332, 432, 532) in einer Laminierungsstruktur angeordnet sind und die Luftzuführeinheit (131, 531) an dem oberen Abschnitt der n perforierten Platten (132, 232, 332, 432, 532) installiert ist; und
wobei n eine ganze Zahl gleich oder größer als 2 ist, **dadurch gekennzeichnet, dass**
jede der perforierten Platten (132, 232, 332, 432, 532) mehrere Löcher (1321, 2321, 5321) (1321, 2321, 5321) aufweist und
wobei ein Durchmesser der Löcher (1321, 2321, 5321), die in einem zentralen Bereich der perforierten Platte (132, 232, 332, 432, 532) angeordnet sind, größer ist als ein Durchmesser der Löcher (1321, 2321, 5321), die in einem Randbereich der perforierten Platte (132, 232, 332, 432, 532) angeordnet sind.

3. System zum Laden und Entladen einer Batterie, wobei das System Folgendes aufweist:
ein Fach (110), das eingerichtet ist, mehrere Batteriezellen (111, 511) aufzunehmen;
eine Lade- und Entladeeinheit (120), die eingerichtet ist, mit einer ersten Elektrodenleitung und einer zweiten Elektrodenleitung der mehreren Batteriezellen (111, 511), die in dem Fach (110) aufgenommen sind, elektrisch verbunden zu werden; und
eine Kühleinheit (130), die eingerichtet ist, die mehreren Batteriezellen (111, 511), die in dem Fach (110) aufgenommen sind, zu kühlen,
wobei die Kühleinheit (130) eine Luftzuführeinheit (131, 531), die an einem oberen Abschnitt des Fachs (110) positioniert ist, und n perforierte Platten (132, 232, 332, 432, 532) aufweist, die auf einem Luftströmungsweg der Luftzuführeinheit (131, 531) positioniert sind, wobei die perforierten Platten (132, 232, 332, 432, 532) in einer Laminierungsstruktur angeordnet sind und die Luftzuführeinheit (131, 531) an dem oberen Abschnitt der n perforierten Platten (132, 232, 332, 432, 532) installiert ist; und
wobei n eine ganze Zahl gleich oder größer als 2 ist, **dadurch gekennzeichnet, dass**
jede der perforierten Platten (132, 232, 332, 432, 532) mehrere Schlitze (3322, 4322) parallel zueinander aufweist und die Schlitze (3322, 4322) in einem zentralen Bereich jeder perforierten Platte (132, 232, 332, 432, 532) angeordnet sind.

4. System zum Laden und Entladen einer Batterie, wobei das System Folgendes aufweist:
ein Fach (110), das eingerichtet ist, mehrere Batteriezellen (111, 511) aufzunehmen;
eine Lade- und Entladeeinheit (120), die eingerichtet ist, mit einer ersten Elektrodenleitung und einer zweiten Elektrodenleitung der mehreren Batteriezellen (111, 511), die in dem Fach (110) aufgenommen sind, elektrisch verbunden zu werden; und
eine Kühleinheit (130), die eingerichtet ist, die mehreren Batteriezellen (111, 511), die in dem Fach (110) aufgenommen sind, zu kühlen,
wobei die Kühleinheit (130) eine Luftzuführeinheit (131, 531), die an einem oberen Abschnitt des Fachs (110) positioniert ist, und n perforierte Platten (132, 232, 332, 432, 532) aufweist, die auf einem Luftströmungsweg der Luftzuführeinheit (131, 531) positioniert sind, wobei die perforierten Platten (132, 232, 332, 432, 532) in einer Laminierungsstruktur angeordnet sind und die Luftzuführeinheit (131, 531) an dem oberen Abschnitt der n perforierten Platten (132, 232, 332, 432, 532) installiert ist; und
wobei n eine ganze Zahl gleich oder größer als 2 ist, **dadurch gekennzeichnet, dass**
jede der perforierten Platten (132, 232, 332, 432, 532) mehrere Schlitze (3322, 4322) aufweist und
wobei eine Breite der Schlitze, die in einem zentralen Bereich der perforierten Platte (132, 232, 332, 432, 532) angeordnet sind, größer ist als eine Breite der Schlitze (3322, 4322), die in einem Randbereich der perforierten Platte (132, 232, 332, 432, 532) angeordnet sind.

5. System nach einem der vorhergehenden Ansprüche, wobei n eine ganze Zahl von 2 bis 5 ist.

6. System nach einem der vorhergehenden Ansprüche, wobei die Luftzuführeinheit (131, 531) als mehrere Luftzuführeinheiten (131, 531) bereitgestellt ist und die Luftzuführeinheiten (131, 531) an dem oberen Abschnitt des Tabletts (110) in regelmäßigen Abständen angeordnet sind.

7. System nach einem der vorhergehenden Ansprüche, wobei die Luftzuführeinheit (131, 531) ein Gebläse ist.

8. System nach einem der vorhergehenden Ansprüche, wobei die mehreren Batteriezellen (111, 511), die in dem Fach (110) aufgenommen sind, vertikal angeordnet sind, und
wobei die Kühleinheit (130) eingerichtet ist, Luft so zu blasen, dass sie sich durch die Luftzuführeinheit (131, 531), die an dem oberen Abschnitt des Fachs (110) positioniert ist, nach unten zu bewegen.

9. System nach einem der vorhergehenden Ansprüche, wobei die mehreren Batteriezellen (111, 511), die in dem Fach (110) aufgenommen sind, pouch-förmige Batteriezellen (111, 511) sind.

10. System nach einem der vorhergehenden Ansprüche, wobei das Fach (110) eine offene Seitenfläche aufweist, und
wobei die Kühleinheit (130) ferner eine Unterluftzuführeinheit (140) aufweist, die Kühlluft zu den Batteriezellen (111, 511) an der offenen Seitenfläche des Fachs (110) bläst.

11. System nach einem der vorhergehenden Ansprüche, das ferner einen Temperatursensor aufweist, der eine Temperatur der Batteriezellen (111, 511) misst, die in dem Fach (110) aufgenommen sind.

## Revendications

1. Système destiné à charger et décharger une batterie, le système comprenant :
un bac (110) configuré pour accueillir une pluralité de cellules de batterie (111, 511) ;
une unité de charge et décharge (120) configurée pour être connectée électriquement à des premier et deuxième fils d'électrode de la pluralité de cellules de batterie (111, 511) accueillies dans le bac (110) ; et
une unité de refroidissement(130) configurée pour refroidir la pluralité de cellules de batterie (111, 511) accueillies dans le bac (110),
dans lequel l'unité de refroidissement (130) inclut une unité d'alimentation en air (131, 531) positionnée à une partie supérieure du bac (110), et n plaques perforées (132, 232, 332, 432, 532) qui sont positionnées sur un trajet d'écoulement d'air de l'unité d'alimentation en air (131, 531), les plaques perforées (132, 232, 332, 432, 532) étant agencées dans une structure de stratification, et l'unité d'alimentation en air (131, 531) étant installée sur la partie supérieure des n plaques perforées (132, 232, 332, 432, 532) ; et
dans lequel n est un nombre entier égal ou supérieur à 2, **caractérisé en ce que**
chacune des plaques perforées (132, 232, 332, 432, 532) a une pluralité de trous (1321, 2321, 5321), et les trous (1321, 2321, 5321) sont situés dans une région centrale de la plaque perforée (132, 232, 332, 432, 532).

2. Système destiné à charger et décharger une batterie, le système comprenant :
un bac (110) configurée pour accueillir une pluralité de cellules de batterie (111, 511) ;
une unité de charge et décharge (120) configurée pour être connectée électriquement à des premier et deuxième fils d'électrode de la pluralité de cellules de batterie (111, 511) accueillies dans le bac (110) ; et
une unité de refroidissement(130) configurée pour refroidir la pluralité de cellules de batterie (111, 511) accueillies dans le bac (110),
dans lequel l'unité de refroidissement(130) inclut une unité d'alimentation en air (131, 531) positionnée à une partie supérieure du bac (110), et n plaques perforées (132, 232, 332, 432, 532) qui sont positionnées sur un trajet d'écoulement d'air de l'unité d'alimentation en air (131, 531), les plaques perforées (132, 232, 332, 432, 532) étant agencées dans une structure de stratification, et l'unité d'alimentation en air (131, 531) étant installée sur la partie supérieure des n plaques perforées (132, 232, 332, 432, 532) ; et
dans lequel n est un nombre entier égal ou supérieur à 2, **caractérisé en ce que**
chacune des plaques perforées (132, 232, 332, 432, 532) a une pluralité de trous (1321, 2321, 5321) (1321, 2321, 5321), et
dans lequel un diamètre des trous (1321, 2321, 5321) situés dans une région centrale de la plaque perforée (132, 232, 332, 432, 532) est supérieur à un diamètre des trous (1321, 2321, 5321) situés à une région de bordure de la plaque perforée (132, 232, 332, 432, 532).

3. Système destiné à charger et décharger une batterie, le système comprenant :
un bac (110) configuré pour accueillir une pluralité de cellules de batterie (111, 511) ;
une unité de charge et décharge (120) configurée pour être connectée électriquement à des premier et deuxième fils d'électrode de la pluralité de cellules de batterie (111, 511) accueillies dans le bac (110) ; et
une unité de refroidissement(130) configurée pour refroidir la pluralité de cellules de batterie (111, 511) accueillies dans le bac (110),
dans lequel l'unité de refroidissement(130) inclut une unité d'alimentation en air (131, 531) positionnée à une partie supérieure du bac (110), et n plaques perforées (132, 232, 332, 432, 532) qui sont positionnées sur un trajet d'écoulement d'air de l'unité d'alimentation en air (131, 531), les plaques perforées (132, 232, 332, 432, 532) étant agencées dans une structure de stratification, et l'unité d'alimentation en air (131, 531) étant installée sur la partie supérieure des n plaques perforées (132, 232, 332, 432, 532) ; et
dans lequel n est un nombre entier égal ou supérieur à 2, **caractérisé en ce que**
chacune des plaques perforées (132, 232, 332, 432, 532) a une pluralité de fentes (3322, 4322) parallèles les unes aux autres, et les fentes (3322, 4322) sont situées dans une région centrale de chaque plaque perforée (132, 232, 332, 432, 532).

4. Système destiné à charger et décharger une batterie, le système comprenant :
un bac (110) configuré pour accueillir une pluralité de cellules de batterie (111, 511) ;
une unité de charge et décharge (120) configurée pour être connectée électriquement à des premier et deuxième fils d'électrode de la pluralité de cellules de batterie (111, 511) accueillies dans le bac (110) ; et
une unité de refroidissement(130) configurée pour refroidir la pluralité de cellules de batterie (111, 511) accueillies dans le bac (110),
dans lequel l'unité de refroidissement(130) inclut une unité d'alimentation en air (131, 531) positionnée à une partie supérieure du bac (110), et n plaques perforées (132, 232, 332, 432, 532) qui sont positionnées sur un trajet d'écoulement d'air de l'unité d'alimentation en air (131, 531), les plaques perforées (132, 232, 332, 432, 532) étant agencées dans une structure de stratification, et l'unité d'alimentation en air (131, 531) étant installée sur la partie supérieure des n plaques perforées (132, 232, 332, 432, 532) ; et
dans lequel n est un nombre entier égal ou supérieur à 2, **caractérisé en ce que**
chacune des plaques perforées (132, 232, 332, 432, 532) a une pluralité de fentes (3322, 4322), et
dans lequel une largeur des fentes situées dans une région centrale de la plaque perforée (132, 232, 332, 432, 532) est supérieure à une largeur des fentes (3322, 4322) situées à une région de bordure de la plaque perforée (132, 232, 332, 432, 532).

5. Système selon l'une quelconque des revendications précédentes, dans lequel n est un nombre entier de 2 à 5.

6. Système selon l'une quelconque des revendications précédentes, dans lequel l'unité d'alimentation en air (131, 531) est munie d'une pluralité d'unités d'alimentation en air (131, 531), et les unités d'alimentation en air (131, 531) sont agencées à la partie supérieure du bac (110) à intervalles réguliers.

7. Système selon l'une quelconque des revendications précédentes, dans lequel l'unité d'alimentation en air (131, 531) est un ventilateur soufflant.

8. Système selon l'une quelconque des revendications précédentes, dans lequel la pluralité de cellules de batterie (111, 511) accueillies dans le bac (110) sont agencées verticalement, et
dans lequel l'unité de refroidissement(130) est configurée pour souffler de l'air pour se déplacer vers le bas à travers l'unité d'alimentation en air (131, 531) positionnée à la partie supérieure du bac (110).

9. Système selon l'une quelconque des revendications précédentes, dans lequel la pluralité de cellules de batterie (111, 511) accueillies dans le bac (110) sont des cellules de batterie de type poche (111, 511).

10. Système selon l'une quelconque des revendications précédentes, dans lequel le bac (110) a une surface latérale ouverte, et
dans lequel l'unité de refroidissement(130) inclut en outre une sous-unité d'alimentation en air (140) qui souffle de l'air de refroidissement vers les cellules de batterie (111, 511) à la surface latérale ouverte du bac (110).

11. Système selon l'une quelconque des revendications précédentes, comprenant en outre un capteur de température qui mesure une température des cellules de batterie (111, 511) accueillies dans le bac (110).
